# EUROPÄISCHE PATENTANMELDUNG

(11) **EP 0 569 745 A1**
(43) Veröffentlichungstag der Anmeldung: **18.11.1993**
(21) Anmeldenummer: 93106507.2
(22) Anmeldetag: 21.04.1993
(51) Int. Cl.: H01L 21/28, H01L 29/60

(54) **Verfahren zur Herstellung eines Feldeffekttransistoren mit asymmetrischer Gate-Struktur**

(30) Priorität: 14.05.1992 DE 4215985
(71) Anmelder: SIEMENS AKTIENGESELLSCHAFT, D-80333 München (DE)
(72) Erfinder: Ristow, Dietrich, Dr., W-8014 Neubiberg (DE)

(57) **Zusammenfassung**

Verfahren zur Herstellung eines FET, bei dem durch schräges Aufdampfen einer Hilfsschicht (5) in den Recess (4) des Gate-Bereiches erreicht wird, daß ein sourceseitiger Spacer (6) entfernt werden kann, während ein drainseitiger Spacer (7) stehenbleibt, und dadurch erreicht wird, daß nach dem Aufbringen weiterer Spacer (9) die Gate-Metallisierung (12) näher an Source als an Drain positioniert wird.

## Beschreibung

Die vorliegende Erfindung betrifft ein Verfahren zur Herstellung eines Feldeffekttransistors mit extrem kurzer Gatelänge.

Bei Feldeffekttransistoren, insbesondere MESFET's oder HEMT's, soll auf der Source-Seite der Abstand zwischen Gate und Kontaktschicht möglichst klein gehalten werden, damit der parasitäre Source-Widerstand möglichst klein ist. Andererseits soll auf der Drain-Seite der Abstand zwischen Gate und Kontaktschicht relativ groß sein, damit die Durchbruchspannung zwischen Gate und Drain ausreichend groß wird und zugleich die Gate-Drain-Kapazität möglichst klein wird. Bisher wurden zu diesem Zweck selbstjustierende Verfahren eingesetzt, wenn die geforderte Durchbruchspannung nicht zu hoch lag. Dabei blieb der Abstand zwischen dem Gate und der n⁺-Kontaktschicht source- und drainseitig gleich (symmetrische Lage von Source und Drain um das Gate). Für höhere Durchbruchsspannungen wurde mit einem zusätzlichen Fototechnik-Justierschritt auf der Drainseite der Abstand zur Kontaktschicht vergrößert. Derartige Verfahren sind z. B. in den Patentschriften US 4 196 439 und US 4 956 308 beschrieben. In der US 4 300 148 wird vorgeschlagen, die Dicke der aktiven Schicht drainseitig vom Gate so dünn bzw. so niedrig dotiert zu machen, daß sie gerade das Maximum des möglichen Stroms unter dem Gate aufnehmen kann.

Aufgabe der vorliegenden Erfindung ist es, ein einfach durchführbares Verfahren für die Herstellung eines Feldeffekttransistors mit hoher Durchbruchspannung und kleiner Gate-Drain-Kapazität anzugeben.

Diese Aufgabe wird mit dem Verfahren mit den Merkmalen des Anspruches 1 gelöst. Weitere Ausgestaltungen ergeben sich aus den abhängigen Ansprüchen.

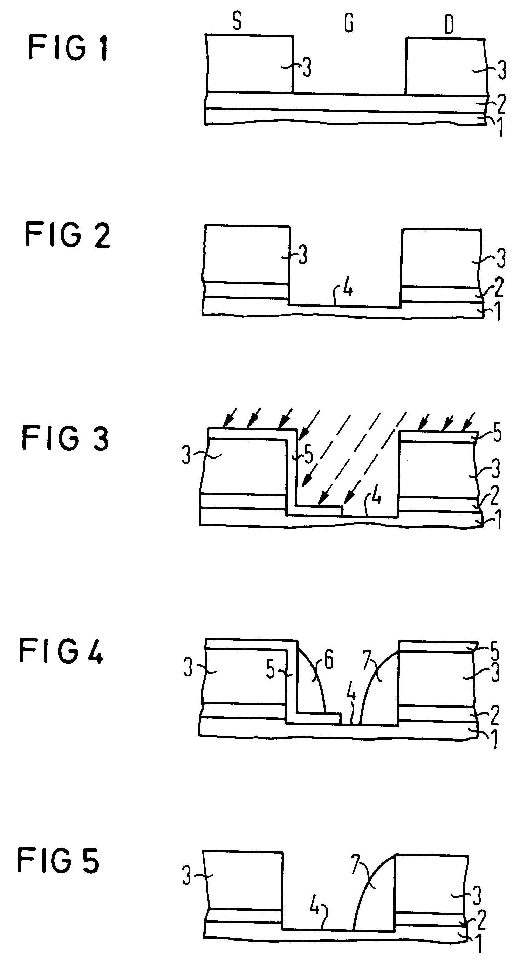

Es folgt eine Beschreibung des erfindungsgemäßen Verfahrens anhand der Figuren 1 bis 13, die einen FET im Querschnitt nach verschiedenen Verfahrensschritten zeigen.

Bei dem erfindungsgemäßen Verfahren wird nur ein Fototechnikschritt angewendet, um einen unsymmetrischen Abstand des Gate von den Kontaktschichtanteilen von Source und Drain zu erhalten und ggf. zugleich auf der Drainseite eine zusätzliche Ätzstufe (Doppelrecess) im Übergang zur Kontaktschicht zu erzeugen. Außerdem kann ausgehend von einer lichtoptischen Lithographie eine effektive Gate-Länge von 0,2 µm erzeugt werden. Bei diesem Verfahren wird eine für Feldeffekttransistoren übliche Schichtfolge aus Halbleitermaterial mit mindestens der für das Gate vorgesehenen Schicht 1 (s. Fig. 1) und darauf einer hochdotierten Kontaktschicht 2 für Source und Drain hergestellt. Diese Schichten können z. B. auf einem Halbleitersubstrat (z. B. aus GaAs) epitaktisch aufgewachsen werden. Die Schichten können auch in dem Wafer durch Ionenimplantation hergestellt werden. Bei einem ionenimplantierten MESFET besteht die genannte Schichtfolge aus einer Kanalschicht und einer hochdotierten Kontaktschicht übereinander z. B. auf einem semiisolierenden GaAs-Substrat. Die Kanalschicht und die Kontaktschicht können ebenfalls GaAs sein. Bei einem epitaktisch aufgewachsenen HEMT ist die Schichtfolge z. B. eine Pufferschicht auf einem semiisolierenden Substrat, die sehr schwach oder gar nicht dotiert ist, darauf eine einen Heteroübergang bildende weitere Schicht, darauf eine Zwischenschicht und schließlich eine hochdotierte Kontaktschicht. Das Substrat ist z. B. GaAs, ebenso die Pufferschicht und die Kontaktschicht. Die den Heteroübergang bildende Schicht ist z. B. AlGaAs. Die darauf aufgebrachte Zwischenschicht ist GaAs oder AlGaAs. Diese Schichtfolgen sind nur als Beispiel angegeben; es können ebenso gut andere für Feldeffekttransistoren gebräuchliche Schichtfolgen hergestellt werden. Die in den Figuren gezeichnete Schicht 1 bezeichnet in jedem Ausführungsbeispiel die zwischen dem Substrat und der Kontaktschicht angeordnete Schicht oder Schichtfolge.

Auf dieser Schichtfolge wird eine Maske 3 aufgebracht. Das geschieht z. B. durch ganzflächiges Aufbringen einer dielektrischen Passivierungsschicht (z. B. PCVD-SiN 0,2 µm dick). Danach wird in dieser Passivierungsschicht mittels Fototechnik eine Öffnung von z. B. 0,6 µm Länge hergestellt. Diese Bemessung von 0,6 µm ist dabei für die Richtung, in der Source, Gate und Drain bei den fertigen FET liegen, angegeben. Weil die Schichten aus Halbleitermaterial, auf denen diese Passivierungsschicht aufgebracht wurde, noch vollkommen planar sind, sind die Voraussetzungen der Fotolithographie für ein Einhalten dieser Bemessung mit der geringstmöglichen Streuung gegeben. Deswegen und wegen der leichten Reproduzierbarkeit der Bedingungen, unter denen die nachfolgenden Verfahrensschritten ablaufen, ist das erfindungsgemäße Verfahren stets wiederholbar und ist geeignet, eine hohe Stückzahl von praktisch identischen FET's zu produzieren. Die Öffnung in der Passivierungsschicht wird z. B. mit CF₄-RIE geätzt.

Durch die Öffnung dieser Maske 3, die in Fig. 1 dargestellt ist, wird nachfolgend ein Recess 4 geätzt. Dabei wird z. B. mittels Cl-RIE die Kontaktschicht 2 im Bereich dieser Öffnung teilweise oder ganz entfernt und ggf. noch bis in die Schicht 1 hinein geätzt, je nachdem wie es die Schichtdicken, der Strom und die Einsatzspannung des betreffenden Transistors erfordern. Dieser Recess 4 hat beispielsweise eine Tiefe von 100 nm. Das Ergebnis dieses Verfahrensschrittes ist in Fig. 2 dargestellt.

Bei einem ersten Ausführungsbeispiel des erfindungsgemäßen Verfahrens wird dann wie in Fig. 3 gezeigt durch schräges Aufdampfen auf der Source-Seite unsymmetrisch eine Hilfsschicht 5 aufgebracht. In den Figuren sind Source jeweils links und Drain jeweils rechts gezeichnet, wie das in Fig. 1 mit den Buchstaben S (Source), G (Gate) und D (Drain) stellvertretend für alle Figuren bezeichnet ist. Als diese Hilfsschicht 5 wird z. B. Metall (geeignet ist insbesondere Aluminium) aufgedampft. Bei den bisher angegebenen Bemessungen kann die Hilfsschicht z. B. 50 nm dick sein und das Aufdampfen aus einem Winkel von etwa 45° zu der Schichtebene erfolgen. Damit wird erreicht, daß die Hilfsschicht 5 die Oberfläche der Schicht 1 im Bereich des Recess 4 nur sourceseitig bedeckt. Das Aufdampfen der Hilfsschicht 5 ist in Fig. 3 mit den schräg eingezeichneten Pfeilen angedeutet.

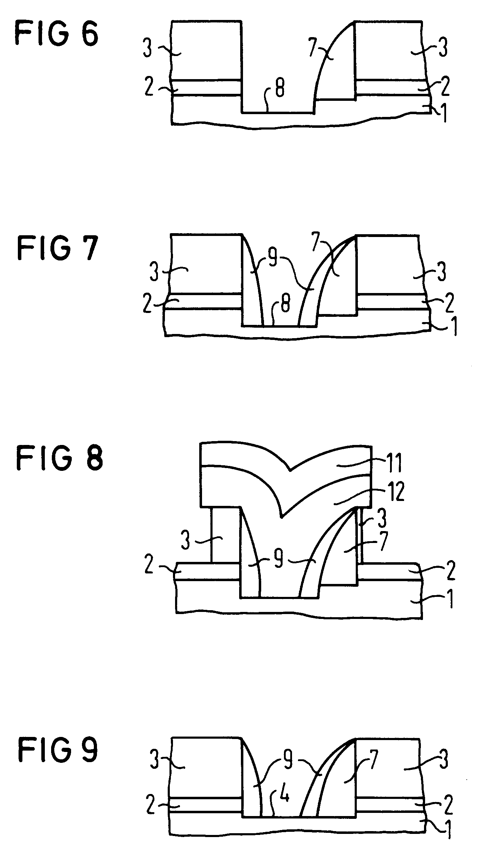

In einem weiteren Verfahrensschritt werden Spacer sourceseitig und drainseitig in der Öffnung hergestellt, was mittels eines der üblichen Verfahren, wie sie z. B. in der deutschen Patentanmeldung P 42 11 0 51.3 beschrieben sind, erfolgen kann. Diese Spacer sind z. B. aus SiN und besitzen eine in der Zeichenebene von Fig. 4 gemessene Breite am Fußpunkt von etwa 0,2 µm. Die Dicke dieser Spacer 6, 7 wird dabei so gewählt, daß der sourceseitige Spacer 6 nur auf der Hilfsschicht 5 sitzt. Die Dicke dieser Hilfsschicht 5 und die Richtung, aus der sie aufgedampft wird, ist daher in dem vorhergehenden Verfahrensschritt auch im Hinblick darauf einzustellen, daß der nachfolgend hergestellte sourceseitige Spacer 6 auf dem sourceseitigen Anteil der Hilfsschicht 5 Platz finden muß. Nach diesem Verfahrensschritt ist der Aufbau nach Fig. 4 erreicht. Der sourceseitige Spacer 6 kann dann entfernt werden, indem die Hilfsschicht 5 entfernt wird. Falls die Hilfsschicht 5 Aluminium ist, kann sie z. B. mit flüssigem HCl (Salzsäure) entfernt werden. Es bleibt danach nur der drainseitige Spacer 7 entsprechend Fig. 5.

Auf dem jetzt freiliegenden Anteil der Schicht 1 können dann weitere Spacer 9 hergestellt werden. Zuvor ist es möglich, durch Ätzen eines zweiten Recess 8 in die Schicht 1 die Einsatzspannung des Transistors genauer festzulegen (s. Fig. 6). Um sicherzustellen, daß dieser zweite Recess 8 bis zu einer vorgegebenen Tiefe geätzt wird, kann die Schicht 1 eine Schicht folge mit einer geeigneten Ätzstoppschicht enthalten. Diese Ätzstoppschicht ist dann auf der Höhe der Schichtfolge angeordnet, bis zu der das Ätzen des zweiten Recess 8 erfolgen soll. Auf diese Weise kann die Einsatzspannung des Transistors sehr genau reproduzierbar festgelegt werden. Fig. 7 zeigt einen Querschnitt des FET's nach dem Herstellen der weiteren Spacer 9 auf der Oberfläche der Schicht 1 mit dem zweiten Recess 8.

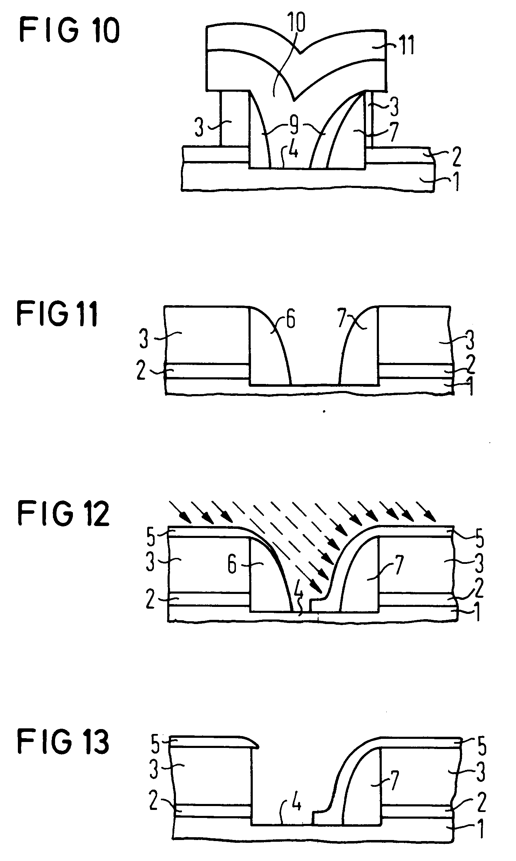

Die Alternative ohne zweiten Recess 8 ist in Fig. 9 dargestellt. Der sourceseitige weitere Spacer isoliert insbesondere die Kontaktschicht 2 auf der Source-Seite von der nachfolgend aufzubringenden Gate-Metallisierung. Die weiteren Spacer 9 werden vorzugsweise aus dem gleichen Material wie die ersten Spacer (z. B. SiN) hergestellt. In dem vorliegenden Ausführungsbeispiel werden diese weiteren Spacer 9 z. B. mit einer Breite von 0,1 µm an dem Fußpunkt, d. h. auf der Kanalschicht 1 hergestellt. Wenn man von der Länge von 0,6 µm der Maskenöffnung die jeweiligen Abmessungen der Spacer an den Fußpunkten suttrahiert, resultiert eine Gatelänge, d. h. die Länge der mit der Gate-Metallisierung zu versehenden Oberfläche der Schicht 1 in Richtung von Source nach Drain, von 0,2 µm. Damit ist eine extrem kurze Gatelänge von 0,2 µm bei gleichzeitiger unsymmetrischer Ausrichtung des Gates in bezug auf Source und Drain realisiert.
Nachfolgend werden dann die Gate-Metallisierung 10, 12 und die Gate-Verstärkung 11 aufgebracht, wobei die Gate-Verstärkung 11 zugleich als Ätzmaske dient, um die Gate-Metallisierung 10, 12 zu strukturieren. Beim Ätzen der Maske 3 wird die Gate-Metallisierung 10, 12 geringfügig unterätzt, so daß die Metallisierungen für Source und Drain aufgebracht werden können, wie es von herkömmlichen Herstellungsverfahren her bekannt ist. Das Resultat nach dem Rückätzen der Maske 3 bis auf sourceseitige und drainseitige Anteile ist in Fig. 8 bzw. Fig. 10 (Beispiel ohne zweiten Recess 8) dargestellt.

Unabhängig von den wesentlichen Schritten der vorliegenden Erfindung sollte bei der Justierung der Gateverstärkung 11 auf der Drainseite darauf geachtet werden, daß die Verstärkung die Kontaktschicht 2 nicht unnötig weit überragt, damit die Drain-Gate-Kapazität klein bleibt. Deswegen ist in Fig. 8 bzw. in Fig. 10 die Gate-Verstärkung 11 unsymmetrisch zu den beiden Kanten der Kontaktschicht 2 gezeichnet, obwohl das für das erfindungsgemäße Verfahren nicht wesentlich ist.

Es wird im folgenden ein zweites Ausführungsbeispiel beschrieben, bei der die Hilfsschicht als Ätzmaske verwendet wird. Die Verfahrensschritte, die in den Fig. 1 und 2 dargestellt sind, werden bei dieser Variante in der gleichen Weise wie bei dem ersten Ausführungsbeispiel durchgeführt. Danach wird nicht sogleich die Hilfsschicht aufgebracht, sondern zunächst auf der Kanalschicht 1 die Spacer 6, 7 hergestellt (s. Fig. 11). Dann wird die Hilfsschicht 5, die wieder z. B. Metall, insbesondere Aluminium sein kann, diesmal aber schräg aus der Richtung von Source aufgedampft. Dieses Aufbringen der Hilfsschicht 5 erfolgt derart, daß der drainseitige Spacer 7 von dieser Hilfsschicht 5 vollständig abgedeckt wird (s. Fig. 12). Die Hilfsschicht 5 kann in diesem zweiten Ausführungsbeispiel dicker sein als in dem ersten, hier z. B. 150 nm.

In einem weiteren Schritt wird der sourceseitige Spacer 6 entfernt. Das geschieht z. B. mittels CF₄-RIE. Das Material der Hilfsschicht 5 dient dabei als Ätzmaske, die den drainseitigen Spacer 7 schützt. Eine gewisse Beschädigung der Kristallstruktur an der Oberfläche des Halbleitermateriales auf der Source-Seite (oberflächennahes Kristall-Damage) durch das RIE kann dabei in Kauf genommen werden, da die betroffene Oberflächenschicht der Schicht 1 in einem nachfolgenden Verfahrensschritt (bei der Herstellung eines zweiten Recess) weggeätzt werden kann. Nachdem die Hilfsschicht 5 entfernt worden ist, was bei Verwendung von Aluminium z. B. mittels HCL geschehen kann, ergibt sich die Anordnung der Fig. 5. Die daran sich anschließenden Verfahrensschritte entsprechen denen der Figuren 6 bis 8 bzw. 9 und 10.

Wesentlich bei dem Verfahren der Erfindung ist es, daß auf der Drain-Seite ein zusätzlicher Spacer hergestellt wird, wodurch erreicht wird, daß die Gate-Metallisierung zur Source-Seite hin verschoben positioniert wird. Dieses Verfahren ist insbesondere vorteilhaft, wenn Transistoren mit extrem kurzer Gate-Länge hergestellt werden sollen (z. B. für hohe Frequenzen). Die deutlichste Verbesserung gegenüber dem Stand der Technik erreicht man damit etwa für Gate-Längen bis 0,4 µm, es kann aber auch für größere Bemessungen angewendet werden.

## Patentansprüche

1. Verfahren zur Herstellung eines Feldeffekttransistors, bei dem
in einem ersten Schritt auf einer Schichtfolge, die mindestens eine für ein Gate vorgesehene Schicht (1) und eine hoch dotierte Kontaktschicht (2) umfaßt, eine Maske (3) mit einer Öffnung im Bereich des herzustellenden Gates aufgebracht wird,
in einem zweiten Schritt ein Recess (4) in diesem Bereich hergestellt wird, indem dort mindestens die Dicke der Kontaktschicht (2) vermindert wird,
in einem dritten Schritt source- und drainseitige Spacer (6, 7) in der Öffnung hergestellt werden,
in einem vierten Schritt der sourceseitige Spacer (6) entfernt wird,
in einem fünften Schritt weitere Spacer (9) hergestellt werden,
in einem sechsten Schritt eine Gate-Metallisierung (10, 12) zwischen diesen weiteren Spacern (9) und durch diese von der Kontaktschicht (2) elektrisch isoliert auf der Kanalschicht (1) aufgebracht wird und Metallisierungen für Source und Drain hergestellt werden.

2. Verfahren nach Anspruch 1,
bei dem
zwischen dem zweiten und dem dritten Schritt eine Hilfsschicht (5) derart aufgebracht wird, daß diese Hilfsschicht (5) in dem Recess (4) nur sourceseitig vorhanden ist,
in dem dritten Schritt der sourceseitige Spacer (6) auf dieser Hilfsschicht (5) hergestellt wird und
der vierte Schritt erfolgt, indem die Hilfsschicht (5) und damit der sourceseitige Spacer (6) entfernt werden.

3. Verfahren nach Anspruch 1,
bei dem
zwischen dem dritten und dem vierten Schritt eine Hilfsschicht (5) derart aufgebracht wird, daß nur der drainseitige Spacer (7) von dieser Hilfsschicht (5) vollständig abgedeckt wird,
bei dem diese Hilfsschicht (5) aus einem Material ist, bezüglich dessen der sourceseitige Spacer (6) selektiv entfernt werden kann, und
bei dem zwischen dem vierten Schritt und dem fünften Schritt die Hilfsschicht (5) entfernt wird.

4. Verfahren nach Anspruch 2 oder 3,
bei dem die Hilfsschicht (5) aus einer Richtung aufgebracht wird, die bezüglich der Senkrechten auf einer die Orientierung der Schicht folge festlegenden Ebene geneigt ist.

5. Verfahren nach einem der Ansprüche 2 bis 4,
bei dem die Hilfsschicht (5) Metall ist.

6. Verfahren nach einem der Ansprüche 1 bis 5,
bei dem vor dem fünften Schritt ein zweiter Recess (8) in der Kanalschicht (1) hergestellt wird.

7. Verfahren nach einem der Ansprüche 1 bis 6,
bei dem die Bemessungen der Öffnung in der Maske (3), des drainseitigen Spacers (7) und der weiteren Spacer (9) so vorgenommen werden, daß die Gatelänge, d. h. die Länge der Kontaktfläche zwischen der Gate-Metallisierung (10, 12) und der Kanalschicht (1) in Richtung von Source nach Drain, maximal 0,4 µm beträgt.
